# EUROPÄISCHE PATENTSCHRIFT

(11) **EP 3 005 566 B1**
(45) Veröffentlichungstag und Bekanntmachung des Hinweises auf die Patenterteilung: **17.02.2021**
(21) Anmeldenummer: 14730759.9
(22) Anmeldetag: 22.05.2014
(51) Int. Cl.: H03K 17/945, G06F 3/01, G06F 3/03

(54) **SCHALTERBETÄTIGUNGSEINRICHTUNG, MOBILES GERÄT UND VERFAHREN ZUM BETÄTIGEN EINES SCHALTERS DURCH EINE PRÄSENZ EINES WÄRME EMITTIERENDEN TEILS**
SWITCH-ACTUATING APPARATUS, MOBILE DEVICE, AND METHOD FOR ACTUATING A SWITCH BY MEANS OF THE PRESENCE OF A HEAT-EMITTING PART
DISPOSITIF D'ACTIONNEMENT DE COMMUTATEUR, APPAREIL MOBILE ET PROCÉDÉ D'ACTIONNEMENT D'UN COMMUTATEUR PAR LA PRÉSENCE D'UNE PARTIE ÉMETTANT DE LA CHALEUR

(30) Priorität: 24.05.2013 US 201361827108 P
(43) Veröffentlichungstag der Anmeldung: 13.04.2016
(73) Patentinhaber: Pyreos Ltd., Edinburgh EH9 3JF (GB)
(72) Erfinder: GIEBELER, Carsten, Edinburgh EH32 0PE (GB); BROWN, Spyros, Edinburgh EH11 2LJ (GB); CHAMBERLAIN, Tim, Edinburgh Eh5 2ad (GB); HURWITZ, Jonathan Ephraim David, Edinburgh EH6 7PJ (GB)
(74) Vertreter: Mewburn Ellis LLP
(86) Internationale Anmeldenummer: PCT/EP2014/060551
(87) Internationale Veröffentlichungsnummer: WO 2014/187904

(56) Entgegenhaltungen:
- WO-A1-82/02270
- WO-A2-2012/066562
- JP-A- 2008 245 086
- US-A1- 2011 050 643
- WOJTCZUK P ET AL: "Recognition of Simple Gestures Using a PIR Sensor Array", SENSORS & TRANSDUCERS, INTERNATIONAL FREQUENCY SENSOR ASSOCIATION, CA, Bd. 14, Nr. 1, 12. März 2012 (2012-03-12), Seiten 83-94, XP002714652, ISSN: 1726-5479

## Beschreibung

Die Erfindung betrifft eine Schalterbetätigungseinrichtung, ein mobiles Gerät mit der Schalterbetätigungseinrichtung und ein Verfahren zur Betätigung eines Schalters mit der Schalterbetätigungseinrichtung durch eine Präsenz eines Wärme emittierenden Teils, insbesondere eines menschlichen Kopfs.

Zur Mensch-Computer-Interaktion sind interaktive Systeme und deren Mensch-Maschine-Schnittstellen bekannt, die mit einer Einrichtung zur automatischen Erkennung von durch Menschen ausgeführten nicht-taktilen oder taktilen Gesten ausgestattet sind. Die Geste kann prinzipiell von jeder Körperhaltung und jeder Körperbewegung abgeleitet werden. Die Gestenerkennungseinrichtung ist mit einem Gerät zur Erfassung der Geste ausgestattet, wobei die dadurch erzeugten Informationen mit entsprechenden Algorithmen ausgewertet werden, um eine Geste aus den Informationen abzuleiten. Herkömmlich ist beispielsweise ein Mobiltelefon mit der Gestenerkennungseinrichtung derart ausgestattet, dass mit der Gestenerkennungseinrichtung detektierbar ist, ob das Mobiltelefon an den Kopf eines Menschen gehalten ist, um entsprechende Funktionen des Mobiltelefons zum Telefonieren zu aktivieren bzw. deaktivieren. Die Gestenerkennungseinrichtung des Mobiltelefons zum Erkennen der Präsenz des menschlichen Kopfs basiert herkömmlich auf die optische Erfassung der Umgebung des Mobiltelefons, wobei, sobald der Kopf von der Gestenerkennungseinrichtung optisch erfasst ist, dessen Präsenz als detektiert gilt. Hierbei ist dem Rechnung zu tragen, dass der menschliche Kopf von anderen dem Mobiltelefon angenäherten menschlichen Körperteilen oder Gegenständen unterschieden werden soll, wobei störende Umgebungseinflüsse, wie beispielsweise eine Veränderung von Lichtverhältnissen, auszublenden sind. Ferner ist es schwierig, die Gestenerkennungseinrichtung derart auszustatten, dass die Treffsicherheit beim Detektieren der Präsenz des menschlichen Kopfs nicht davon beeinträchtigt ist, ob der Mensch eine Mütze oder einen Hut trägt oder welche Frisur der Mensch hat, insbesondere ob der Mensch die Haare lang trägt oder eine Glatze hat.

Das Dokument Wojtczuk P. et al: "Recognition of Simple Gestures Using a PIR Sensor Array", Sensors & Transducers, International Frequency Sensor Association, CA, Bd. 14, Nr. 1, (2012-03-12), Seiten 93-94 offenbart eine Erkennung von einfachen Gesten mit einer PIR-Sensorenanordnung. Das Dokument US 2011/050643 A1 offenbart eine passive infrarotempfindliche Benutzeroberfläche. Das Dokument WO 2012/066562 A2 ein intelligentes richtungsabhängiges Strahlungsschutzsystem. Das Dokument WO 82/02270 A1 offenbart eine auf infrarote Strahlung ansprechende Steuervorrichtung.

Aufgabe der Erfindung ist es eine Schalterbetätigungseinrichtung, ein mobiles Gerät mit der Schalterbetätigungseinrichtung und ein Verfahren zur Betätigung eines Schalters mit der Schalterbetätigungseinrichtung durch eine Präsenz eines Wärme emittierenden Teils zu schaffen, wobei die Schalterbetätigungseinrichtung eine miniaturisierte Bauweise bei günstigen Kosten und geringem Energieverbrauch hat und die Betätigung des Schalters mit der

Schalterbetätigungseinrichtung sicher und fehlerarm ist.

Die Aufgabe wird gelöst mit den Merkmalen der Patentansprüche 1, 5 und 6. Bevorzugte Ausgestaltungen sind in den weiteren

### Patentansprüchen angegeben.

Die erfindungsgemäße Schalterbetätigungseinrichtung weist einen Präsenzsensor zum Betätigen eines Schalters durch eine Präsenz eines Wärme emittierenden Teils an dem Präsenzsensor, wobei die Präsenz von einer Annäherungsphase, bei der das Teil sich dem Präsenzsensor annähert, einer Verharrungsphase, bei der das Teil in der Nähe des Präsenzsensors verharrt, und einer Entfernungsphase, bei der das Teil vom Präsenzsensor weg zu bewegen ist, gebildet ist, wobei der Präsenzsensor eingerichtet ist, vom Teil emittierte Wärme mittels mindestens einem einen Dünnfilm aus pyroelektrischem Material aufweisenden Pixel zu detektieren und pro Pixel ein Signal mit Signalausschlägen entsprechend dem zeitlichen Intensitätsverlauf der vom Pixel detektierten Wärme auszugeben, eine Signalauswerteeinheit, die eingerichtet ist, aus dem zeitlichen Aufeinanderfolgen und der Form der Signalausschläge die Annäherungsphase und die Entfernungsphase zu ermitteln, und einen Aktuator auf, der eingerichtet ist, von der Signalauswerteeinheit angesteuert zu sein und, sobald die Annäherungsphase, oder die Entfernungsphase ermittelt ist, den Schalter zu betätigen. Bevorzugt ist das pyroelektrische Material Bleizirkonattitanat.

Das erfindungsgemäße mobile Gerät weist die Schalterbetätigungseinrichtung auf, wobei der Schalter zum Aktivieren/Deaktivieren einer Funktionalität des mobilen Geräts in diesem verschaltet ist.

Das erfindungsgemäße Verfahren zum Betreiben der Schalterbetätigungseinrichtung weist die Schritte auf: Annähern des Wärme emittierenden Teils an den Präsenzsensor, so dass von dem Pixel der erste Signalausschlag hervorgerufen in der Annäherungsphase an die Signalauswerteeinheit ausgegeben wird, wobei das Signal des Pixels durch die Signalauswerteeinheit ausgewertet wird, so dass der erste Signalausschlag als ein erster absoluter Amplitudenanstieg auf ein erstes Extremum und, nach Verstreichen einer ersten Zeitspanne ab dem Beginn des ersten absoluten Amplitudenanstiegs, ein erster absoluter Amplitudenabfall auf einen Amplitudenwert, dessen Absolutwert zwischen einem ersten vorherbestimmten absoluten Amplitudenwert und dem Absolutwert des Signalniveaus, das bei einem Nichtansprechen des Pixels vorherrscht, liegt, von der Signalauswerteeinheit identifiziert wird; sobald der erste Signalausschlag identifiziert wurde: Ansteuern des Aktuators zum Betätigen des Schalters durch die Signalauswerteeinheit; ab der Identifizierung des ersten Signalausschlags: Aussetzen der Auswertung des Signals des Pixels durch die Signalauswerteeinheit eine vorherbestimmte Wartedauer, die die

Wartephase bildet; Entfernen des Wärme emittierenden Teils von dem Annäherungssensor, so dass von dem Pixel der zweite Signalausschlag hervorgerufen in der Entfernungsphase an die Signalauswerteeinheit ausgegeben wird, wobei das Signal des Pixels durch die Signalauswerteeinheit ausgewertet wird, so dass der zweite Signalausschlag als ein zweiter absoluter Amplitudenanstieg auf ein zweites Extremum und, nach Verstreichen einer zweiten Zeitspanne ab dem Beginn des zweiten absoluten Amplitudenanstiegs, einen zweiten absoluten Amplitudenabfall auf einen Amplitudenwert, dessen Absolutwert zwischen einem zweiten vorherbestimmten absoluten Amplitudenwert und dem Absolutwert des Signalniveaus, das bei einem Nichtansprechen des Pixels vorherrscht, liegt, von der Signalauswerteeinheit identifiziert wird; sobald der zweite Signalausschlag identifiziert wurde: Ansteuern des Aktuators zum Betätigen des Schalters durch die Signalauswerteeinheit.

Dadurch, dass das Pixel den Dünnfilm aus dem pyroelektrischen Material, bevorzugt Bleizirkonattitanat, aufweist, ist das Pixel, das vom Wärme emittierenden Teil während seiner Präsenz in der Nähe des Präsenzsensors erzeugt wird, derart vorteilhaft beschaffen, dass die Erkennung der Präsenz des Wärme emittierenden Teils mit dem erfindungsgemäßen Verfahren sicher und fehlerarm durchführbar ist. Außerdem ist der Präsenzsensor mit dem Pixel derart in einer miniaturisierten Bauweise bei günstigen Kosten herstellbar, dass die Schalterbetätigungseinrichtung für das mobile Gerät vorteilhaft einsatzbar ist. Das Signal wird mit dem Dünnfilm durch die von dem Teil emittierte Wärme erzeugt, so dass der Präsenzsensor mit einer externen Energiequelle nicht mit Energie versorgt zu werden braucht. Damit weist die Schalterbetätigungseinrichtung die Signalauswerteeinheit und den Aktuator als Energieverbraucher auf, so dass insgesamt der Energieverbrauch der Schalterbetätigungseinrichtung für das mobile Gerät vorteilhaft niedrig ist.

Bevorzugtermaßen weist der Präsenzsensor mindestens zwei der Pixel auf. Dadurch sind der Signalauswerteeinheit mindestens zwei unabhängig voneinander erzeugte Signale bereitgestellt, wobei die Ausweitung der Signale und die damit einhergehende Erkennung der Präsenz des Wärme emittierenden Teils vorteilhaft redundant ausgeführt ist.

Das Teil ist bevorzugt ein menschlicher Kopf und die vom Teil emittierte Wärme ist bevorzugt die vom menschlichen Kopf abgestrahlte Körperwärme. Mit den erfindungsgemäßen und/oder bevorzugten Ausgestaltungen der Schalterbetätigungseinrichtung ist die Erkennung der Präsenz des menschlichen Kopfs im Rahmen üblicher menschlicher Bewegungsabläufe besonders sicher und fehlerarm ermöglicht. Dadurch, dass die Erkennung der Präsenz des menschlichen Kopfs auf die Detektion von dessen emittierter Körperwärme fußt, sind die zur Erkennung der Präsenz des Kopfs herangezogenen Signale etwa von der Art der Frisur des Menschen oder ob der Mensch eine Kopfbedeckung trägt so gut wie unbeeinflusst. Dadurch sind etwaige fehlerhafte Betätigungen des Schalters unterbunden, die beispielsweise durch langes Haar oder einer Mütze verursacht sind.

Das Verfahren zum Betreiben der Schalterbetätigungseinrichtung weist bevorzugt den Schritt auf: Überprüfen, ob die Absolutwerte der Amplituden der Signalausschläge über einem vorherbestimmten Amplitudenniveau liegen; ist die Überprüfung positiv, Fortfahren mit dem jeweiligen nächsten Schritt.

Ferner ist es bevorzugt, dass die Wartedauer höchstens fünf Sekunden beträgt. Die erste Zeitdauer liegt bevorzugtermaßen höchstens zwischen 10 ms und 1000 ms. Außerdem ist es bevorzugt, dass die zweite Zeitdauer höchstens zwischen 10 ms und 1000 ms liegt. Der Absolutwert des ersten vorherbestimmten Amplitudenwerts ist bevorzugtermaßen höchstens um 20 % bis 50 % größer als der Absolutwert des Signalniveaus, das bei einem Nichtansprechen des Pixels vorherrscht, bezogen auf den absoluten Amplitudenwert des ersten Extremums. Ferner ist der Absolutwert des zweiten vorherbestimmten Amplitudenwerts höchstens um 20 % bis 50 % größer als der Absolutwert des Signalniveaus, das bei einem Nichtansprechen des Pixels vorherrscht, bezogen auf den absoluten Amplitudenwert des zweiten Extremums.

Das Verfahren zum Betreiben der Schalterbetätigungseinrichtung weist ferner bevorzugt den Schritt auf: Überprüfen, ob das erste Extremum oberhalb und das zweite Extremum unterhalb des Signalniveaus liegt, das bei einem Nichtansprechen des Pixels vorherrscht, oder ob das erste Extremum unterhalb und das zweite Extremum oberhalb des Signalniveaus liegt, das bei einem Nichtansprechen des Pixels vorherrscht; ist die Überprüfung positiv, Fortfahren mit dem jeweiligen nächsten Schritt. Der Annäherungssensor weist bevorzugtermaßen mindestens zwei der Pixel auf, wobei bevorzugt überprüft wird, ob die ersten Signalausschläge und die zweiten Signalausschläge der Pixel jeweils innerhalb einer vorherbestimmten Zeitspanne liegen; ist die Überprüfung positiv, Fortfahren mit dem jeweiligen nächsten Schritt. Hierbei ist es bevorzugt, dass die vorherbestimmte Zeitspanne 30 ms beträgt.

Durch die erfindungsgemäßen und/oder bevorzugten Ausgestaltungen des Verfahrens zum Betreiben der Schalterbetätigungseinrichtung wird vorteilhaft erreicht, dass Störsignale, die etwa durch Einflüsse aus der Umgebung des Präsenzsensors abgegeben werden, die Auswertung durch die Signalauswerteeinheit nicht oder zumindest kaum beeinträchtigen, wodurch die Genauigkeit der Erkennung der Präsenz des Wärme emittierenden Teils und der Betätigung des Schalters erhöht ist. Durch die erfindungsgemäße und/oder bevorzugte Definition der Abläufe der Signalausschläge, die der Präsenz des Wärme emittierenden Teils zugeordnet sind, ist die Treffsicherheit beim Erkennen der Präsenz des Wärme emittierenden Teils aus Störeinflüssen auf den Präsenzsensor vorteilhaft hoch, wodurch eine sichere und fehlerarme Erkennung der Präsenz des Wärme emittierenden Teils ermöglicht ist. Entsprechen beispielsweise die Abläufe der Signalausschläge nicht denjenigen Signalausschlägen, wie sie für die Präsenz des Wärme emittierenden Teils definiert sind, werden diese Signalausschläge nicht als eine Präsenz des Wärme emittierenden Teils interpretiert. In überraschender Weise wird durch das Heranziehen der vom Dünnfilm aus dem pyroelektrischen Material, bevorzugt Bleizirkonattitanat, erzeugten Signalausschläge für die Identifizierung der Präsenz des Wärme emittierenden Teils eine übermäßige Steigerung der Präzision der Erkennung der Präsenz des Wärme emittierenden Teils erzielt.

Im Folgenden wird eine bevorzugte Ausführungsform der Erfindung anhand der beigefügten schematischen Zeichnungen erläutert. Es zeigen:
Figur 1 eine schematische Darstellung eines Mobiltelefons, das an ein Ohr eines menschlichen Kopfs gehalten ist,
Figur 2 eine schematische Darstellung einer erfindungsgemäßen Schalterbetätigungseinrichtung für das Mobiltelefon aus Figur 1,
Figur 3 ein Diagramm mit Amplitudenverläufen von Signalen eines Präsenzsensors aus Figuren 1 und 2 und
Figuren 4 und 5 Detailansichten von Figur 2.

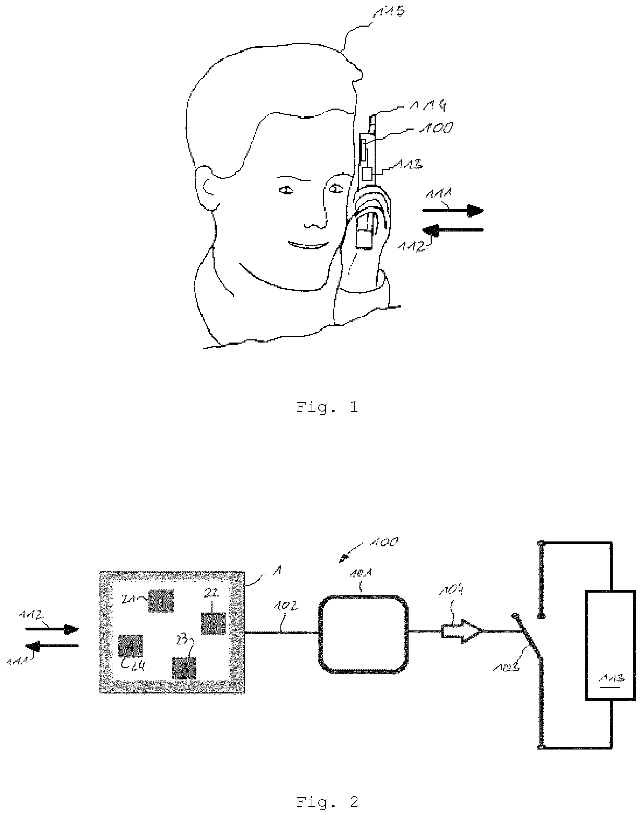

In Figur 1 ist ein Mensch gezeigt, der an dessen Kopf 115 ein Mobiltelefon 114 hält. Das Mobiltelefon 114 wurde an den Kopf 115 mit der Hand durch eine Annäherungsbewegung 112 etwa für ein Telefonat herangeführt. Ist das Telefonat beendet, so wird das Mobiltelefon 114 mit einer Entfernungsbewegung 111 vom Kopf 115 entfernt. Das Mobiltelefon 114 weist eine Schalterbetätigungseinrichtung 100 und eine Funktionseinheit 113 auf, die mit der Schalterbetätigungseinrichtung 100 aktivierbar und deaktivierbar ist. Die Funktionseinheit 113 ist beispielsweise eine Beleuchtungseinrichtung für eine Anzeige des Mobiltelefon 114, die von der Schalterbetätigungseinrichtung 100 derart geschaltet ist, dass die Beleuchtungseinrichtung deaktiviert ist, solange das Mobiltelefon 114 an den Kopf 115 gehalten wird.

Das Mobiltelefon 114 ist beispielsweise eingeschaltet, liegt auf einem Tisch und hat ausreichenden Empfang zum Empfangen von Telefonanrufen. Geht ein Telefonanruf ein, so klingelt das Mobiltelefon 114 und die Beleuchtungseinrichtung wird zum Beleuchten der Anzeige des Mobiltelefons 114 eingeschaltet. Nimmt der Mensch das Mobiltelefon 114 mit der Hand und führt es zu seinem Kopf 115, um nach Annahme des Telefonats dieses zu führen, hält der Mensch das Mobiltelefon 114 an sein Ohr. Sobald das Mobiltelefon 114 in der Nähe des Kopfs 115 ist, deaktiviert die Schalterbetätigungseinrichtung 100 die Beleuchtungseinrichtung, um den Energieverbrauch des Mobiltelefons 114 zu senken und den Kopf 115 mit der Beleuchtungseinrichtung nicht unnötigerweise zu beleuchten.

Die Schalterbetätigungseinrichtung 100 weist einen Präsenzsensor 1 auf, mit dem detektiert wird, dass das Mobiltelefon 114 nahe an den Kopf 115 gehalten wird. Der Präsenzsensor 1 ist via eine Signalleitung 102 mit einer Signalauswerteeinheit 101 verschaltet, in der vom Präsenzsensor 1 auf die Signalauswerteeinheit 101 übertragene Signale ausgewertet werden. Sobald anhand der Signalauswertung in der Signalauswerteeinheit 101 die Präsenz des Kopfs 115 in der Nähe des Mobiltelefons 114 ermittelt ist, wird ein Schalter 103 via einen Aktuator 104 betätigt. Mit dem Schalter 103 ist die Funktionseinheit 113 aktivierbar und deaktivierbar.

Der Präsenzsensor 1 weist ein erstes Pixel 21, ein zweites Pixel 22, ein drittes Pixel 23 und ein viertes Pixel 24 auf.

Die Pixel 21 bis 24 weisen jeweils einen Dünnfilm aus Bleizirkonattitanat auf, mit dem jeweils ein Signal 51 bis 54 erzeugt wird, sobald von dem jeweiligen Pixel 21 bis 24 von dem Kopf 115 emittierte Wärme detektiert wird. Somit wird etwa durch die Präsenz des Kopfs 115 in der Nähe des Präsenzsensors 1 von jedem Pixel 21 bis 24 eines der Signale 51 bis 54 an die Signalauswerteeinheit 101 ausgegeben. Die Verläufe der Signale 51 bis 54 sind analog und entsprechen den zeitlichen Intensitätsverläufen der von den Dünnfilmen der Pixel 21 bis 24 aufgenommenen Wärme, die vom Kopf 115 emittiert wird.

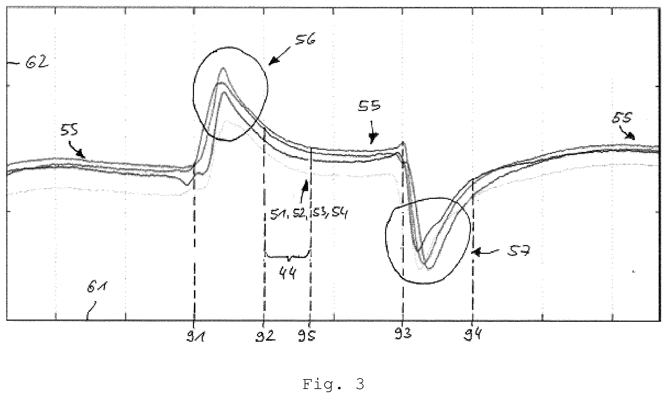

In Figuren 3 bis 5 ist jeweils ein Diagramm gezeigt, über dessen Ordinate 61 die Zeit und dessen Abszisse 62 die Amplituden der Signale 51 bis 54 der Pixel 21 bis 24 aufgetragen sind. Der zeitliche Verlauf der Signale 51 bis 54 ist im Wesentlichen deckungsgleich. Hervorgerufen durch die Annäherungsbewegung 112 ist in den Signalen 51 bis 54 jeweils eine Annäherungsphase 31 zu erkennen, die zu einem ersten Signalausschlag 56 bei den Signalen 51 bis 54 führt. Der erste Signalausschlag 56 setzt sich aus einem ersten absoluten Amplitudenanstieg 32 und einen ersten absoluten Amplitudenabfall 33 zusammen. Der erste absolute Amplitudenanstieg 32 beginnt bei einem Startzeitpunkt 91 und der erste absolute Amplitudenabfall 33 endet bei einem Endzeitpunkt 92, wobei jedes Signal 51 bis 54 beim Übergang vom ersten absoluten Amplitudenanstieg 32 zum ersten absoluten Amplitudenabfall 33 jeweils ein Maximum 81 bis 84 aufweist.

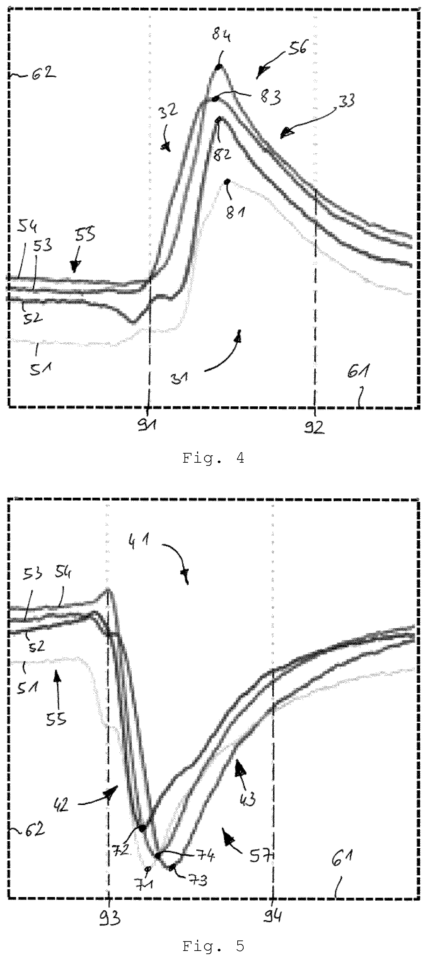

In analoger Weise wird durch die Entfernungsbewegung 111 ein zweiter Signalausschlag 57 der Signale 51 bis 54 verursacht, der eine Entfernungsphase 41 aufweist, die von einem zweiten absoluten Amplitudenanstieg 42 und einem zweiten absoluten Amplitudenabfall 43 gebildet ist. Die Entfernungsphase 41 der Signale 51 bis 54 weist jeweils ein Minimum 71 bis 74 auf. Die Signalausschläge 56, 57 sind entgegengesetzt gerichtet, so dass gemäß Figuren 2 und 3 der erste Signalausschlag 56 nach oben und gemäß Figuren 2 und 4 der zweite Signalausschlag 57 nach unten zeigt. Der Startzeitpunkt des zweiten Signalausschlags 57 ist mit dem Bezugszeichen 93 und der Endzeitpunkt des zweiten Signalausschlags 57 ist mit dem Bezugszeichen 94 bezeichnet.

Durch die Dynamik der Annäherungsbewegung 112 und der Entfernungsbewegung 111 werden von den Pixel 21 bis 24 die Signalausschläge 56 und 57 verursacht, wohingegen bei keiner Präsenz des Kopfs 115 in der Nähe des Präsenzsensors 1 oder bei Stillhalten des Mobiltelefons 114 an dem Kopf 115 Pixelpassivität der Pixel 51 bis 54 vorliegt, deren Signalniveau mit dem Bezugszeichen 55 bezeichnet ist. Bei der Pixelpassivität sind die absoluten Amplitudenwerte der von den Pixel 21 bis 24 ausgegebenen Signale sehr gering, so das im Idealfall davon ausgegangen werden kann, dass das Signalniveau 55 Null beträgt.

Die Schalterbetätigungseinrichtung 100 ist derart geschaltet, dass vom Präsenzsensor 1 ständig Signale 51 bis 54 der Pixel 21 bis 24 an die Signalauswerteeinheit 101 ausgegeben werden. Die Signale 51 bis 54 werden in der Signalauswerteeinheit 101 in Echtzeit dahingehend ausgewertet, ob eine zeitliche Abfolge der Signalausschläge 56 und 57 vorliegt. Wird von der Signalauswerteeinheit 101 der erste Signalausschlag 56 ermittelt, wird von der Signalauswerteeinheit 101 der Aktuator 104 derart betätigt, dass der Schalter 103 geöffnet wird, so dass die Funktionseinheit 113, etwa die Anzeige des Mobiltelefons 114, ausgeschaltet wird. Sobald von der Signalauswerteeinheit 101 der Endzeitpunkt 92 des ersten Signalausschlags 56 ermittelt ist, startet eine Wartephase 44, die bei einem Endzeitpunkt 95 endet und bei der die Auswertung der Signale 51 bis 54 von der Signalauswerteeinheit 101 stillgelegt ist. Erst nach Erreichen des Endzeitpunkts 95 der Wartephase 44 wird von der Signalauswerteeinheit 101 der zweite Signalausschlag 57 erwartet. Sobald die Signalauswerteeinheit 101 den zweiten Signalauswerteeinheit 57 aus den Signalen 51 bis 54 detektiert hat, wird via den Aktuator 104 der Schalter 103 geschlossen, so dass die Funktionseinheit, etwa die Anzeige des Mobiltelefons 114, wieder angeschaltet wird.

Mit Hilfe der Wartephase 44, während der die Signalauswertung der Signalauswerteeinheit 101 stillgelegt ist, wird etwa ein Signalausschlag in Form des zweiten Signalausschlags 57, der während der Wartephase 44 unmittelbar nach dem ersten Signalausschlag 56 erfolgt, nicht als der zweite Signalausschlag 57 identifiziert. Dadurch wird unterbunden, dass eine kurze Abfolge von Signalausschlägen, die beispielsweise durch störende Umgebungseinflüsse erzeugt werden kann, fälschlicherweise als die Präsenz des Mobiltelefons 114 am Kopf 115 identifiziert wird.

Beim Detektieren der Präsenz des Mobiltelefons 114 am Kopf 115 ist im Einzelnen wie folgt vorzugehen:
Indem das Mobiltelefon 114 an den Kopf 115 mit der Annäherungsbewegung 112 während der Annäherungsphase 31 angenähert wird, wird vom Kopf 115 emittierte Wärme von den Pixel 21 bis 24 des Präsenzsensors 1 in immer stärker werdendem Ausmaß detektiert. Dadurch wird von den Pixel 21 bis 24 jeweils der erste Signalausschlag 56 ausgegeben und von der Signalauswerteeinheit 101 identifiziert, nämlich als der erste absolute Amplitudenanstieg 32 auf jeweils das Maximum 81 bis 84 und, nach Verstreichen der Zeitspanne zwischen dem Startzeitpunkt 91 und dem Endzeitpunkt 92 des ersten Signalausschlags 56, der erste absolute Amplitudenabfall 33 auf einen ersten Amplitudenwert. Der erste Amplitudenwert soll höchstens um 20 % bis 50 % größer sein als derjenige Amplitudenwert des Signalniveaus 55, das bei dem Nichtansprechen der Pixel 21 bis 24 vorherrscht, bezogen auf das Maximum 81 bis 84. Die Zeitspanne zwischen dem Startzeitpunkt 91 und dem Endzeitpunkt 92 des ersten Signalausschlags 56 soll höchstens zwischen 20 ms und 50 ms betragen.

Sobald der erste Signalausschlag von der Signalauswerteeinheit 101 identifiziert wurde, wird der Aktuator 104 zum Betätigen des Schalters 103 angesteuert. Ab der Identifizierung des ersten Signalausschlags 56 von der Signalauswerteeinheit 101, also nach Ablauf des Endzeitpunkts 92 des ersten Signalausschlags 56, wird die Auswertung der Signale 51 bis 54 durch die Signalauswerteeinheit 101 während der Wartedauer 54, die zwischen zwei Sekunden und fünf Sekunden betragen soll, ausgesetzt. Nach dem Endzeitpunkt 95 der Wartephase 44 nimmt die Signalauswerteeinheit 101 die Auswertung der Signale 51 bis 54 wieder auf. Sollte während der Wartephase 44 das Mobiltelefon 114 vom Kopf 115 mit der Entfernungsbewegung 111 entfernt worden sein, wird die Signalauswerteeinheit 101 einen zu erwartenden zweiten Signalausschlag 57 nicht identifizieren können. Eine derart kurze Präsenz des Mobiltelefons 114 am Kopf 115 wird nicht als diejenige Präsenz identifiziert, für die die Schalterbetätigungseinrichtung 100 eingerichtet ist die Präsenz des Mobiltelefons 114 am Kopf 115 zu detektieren.

Sobald von der Signalauswerteeinheit 101 der erste Signalausschlag 56 detektiert wurde und die Wartephase 44 abgelaufen ist, befindet sich die Signalauswerteeinheit 101 in einem Zustand, während dem die Signalauswerteeinheit 101 bereit ist den zweiten Signalausschlag 57 durch Auswertung der Signale 51 bis 54 zu identifizieren. Wird nach Ablauf einer vorherbestimmten Zeitspanne von der Signalauswerteeinheit 101 der zweite Signalausschlag 57 nicht identifiziert, wird die Signalauswerteeinheit 101 in ihren ursprünglichen Zustand zurück versetzt, währenddessen die Signalauswerteeinheit 101 bereit ist den ersten Signalausschlag 56 wieder zu identifizieren.

Kann jedoch vor Ablauf dieser vorherbestimmten Zeitspanne von der Signalauswerteeinheit 101 aus den Signalen 51 bis 54 der zweite Signalausschlag 57 identifiziert werden, da das Mobiltelefon 114 vom Kopf 115 mit der Entfernungsbewegung 111 entfernt wurde, wird der Aktuator 104 zum Bestätigen des Schalters 103 durch die Signalauswerteeinheit 101 angesteuert. Der zweite Signalausschlag 57 setzt sich zusammen aus dem zweiten absoluten Amplitudenanstieg 42 auf jeweils eines der Minima 71 bis 74 und, nach Verstreichen der Zeitspanne zwischen dem Startzeitpunkt 93 und dem Endzeitpunkt 94 des zweiten Signalausschlags 57, die höchstens zwischen 20 ms und 50 ms liegen soll, den zweiten absoluten Amplitudenabfall 43 auf einen zweiten Amplitudenwert, der höchstens um 20 % bis 50 % unterhalb des Signalniveaus 55 liegen soll, das bei dem Nichtansprechen der Pixel 21 bis 24 vorherrscht, bezogen auf das Minimum 71 bis 74.

Der erste Signalausschlag 56 wird nur dann als ein solcher von der Signalauswerteeinheit 101 identifiziert, wenn der erste Amplitudenwert nach dem ersten absoluten Amplitudenabfall 33 um maximal 20 % bis 50 % des Amplitudenunterschieds zwischen dem Signalniveau 55 und dem Amplitudenwert im Maximum 81 bis 84 oberhalb des Signalniveaus 55 liegt. Ferner wird der zweite Signalausschlag 57 nur dann als ein solcher von der Signalauswerteeinheit 101 identifiziert, wenn der zweite Amplitudenwert nach dem zweiten absoluten Amplitudenabfall 43 um maximal 20 % bis 50 % des Amplitudenunterschieds zwischen dem Signalniveau 55 und dem Amplitudenwert im Maximum 81 bis 84 oberhalb des Signalniveaus 55 liegt.

Zusätzlich wird überprüft, ob die Absolutwerte der Amplituden der Signalausschläge 56, 57 über einem vorherbestimmten Absolutniveau liegen, wodurch Störeinflüsse aus der Umgebung des Präsenzsensors 1 ausgeblendet werden sollen. Außerdem wird zum Identifizieren der Signalausschläge 56 und 57 überprüft, ob die Maxima 81 bis 84 oberhalb und die Minima 71 bis 74 unterhalb des Signalniveaus 55 liegen, das bei dem Nichtansprechen der Pixel 21 bis 24 vorherrscht. Bei einer entsprechenden gegensinnigen Verschaltung der Pixel 21 bis 24 ist es alternativ denkbar, dass überprüft wird, ob die Orientierung der Signalausschläge 56 und 57 entgegengesetzt der Orientierung ist, wie sie in Figur 2 gezeigt ist. Außerdem wird überprüft, ob jeweils die Maxima 81 bis 84 und die Minima 71 bis 74 innerhalb einer vorherbestimmten Zeitspanne liegen, die 30 ms beträgt. Dadurch wird erreicht, dass die Präsenz des Mobiltelefons 114 am Kopf 115 nur dann detektiert wird, wenn alle Pixel 21 bis 24 dieselbe Signalqualität ihrer Signale 51 bis 54 an die Signalauswerteeinheit 101 abgegeben haben.

### Bezugszeichenliste

- 1: Präsenzsensor
- 21: erstes Pixel
- 22: zweites Pixel
- 23: drittes Pixel
- 24: viertes Pixel
- 31: Annäherungsphase
- 32: erster absoluter Amplitudenanstieg
- 33: erster absoluter Amplitudenabfall
- 41: Entfernungsphase
- 42: zweiter absoluter Amplitudenabfall
- 43: zweiter absoluter Amplitudenanstieg
- 44: Wartephase
- 51: Signal des ersten Pixels
- 52: Signal des zweiten Pixels
- 53: Signal des dritten Pixels
- 54: Signal des vierten Pixels
- 55: Signalniveau bei Pixelpassivität
- 56: erster Signalausschlag bei Annäherungsphase
- 57: zweiter Signalausschlag bei Entfernungsphase
- 61: Ordinate: Zeit
- 62: Abszisse: Amplitude
- 71: erstes Minimum
- 72: zweites Minimum
- 73: drittes Minimum
- 74: viertes Minimum
- 81: erstes Maximum
- 82: zweites Maximum
- 83: drittes Maximum
- 84: viertes Maximum
- 91: Startzeitpunkt des Signalausschlags bei Annäherungsphase
- 92: Endzeitpunkt des Signalausschlags bei Annäherungsphase Startzeitpunkt Wartephase
- 93: Startzeitpunkt des Signalausschlags bei Entfernungsphase
- 94: Endzeitpunkt des Signalausschlags bei Entfernungsphase
- 95: Endzeitpunkt Wartephase
- 100: Schalterbetätigungseinrichtung
- 101: Signalauswerteeinheit
- 102: Signalleitung
- 103: Schalter
- 104: Aktuator
- 111: Entfernungsbewegung
- 112: Annäherungsbewegung
- 113: Funktionseinheit
- 114: Mobiltelefon
- 115: Kopf

## Patentansprüche

1. Schalterbetätigungseinrichtung (100) mit einem Präsenzsensor (1) zum Betätigen eines Schalters (103) durch eine Präsenz eines Wärme emittierenden Teils (115) an dem Präsenzsensor (1), wobei die Präsenz von einer Annäherungsphase (31), bei der das Teil (115) sich dem Präsenzsensor (1) annähert, einer Verharrungsphase, bei der das Teil (115) in der Nähe des Präsenzsensors (1) verharrt, und einer Entfernungsphase (41), bei der das Teil (115) vom Präsenzsensor (1) wegzubewegen ist, gebildet ist, wobei der Präsenzsensor (1) eingerichtet ist, vom Teil (115) emittierte Wärme mittels mindestens einem einen Dünnfilm aus pyroelektrischem Material aufweisenden Pixel (21 bis 24) zu detektieren und pro Pixel (21 bis 24) ein Signal (51 bis 54) mit Signalausschlägen (56, 57) entsprechend dem zeitlichen Intensitätsverlauf der vom Pixel (21 bis 24) detektierte Wärme auszugeben, einer Signalauswerteeinheit (101), die eingerichtet ist, aus dem zeitlichen Aufeinanderfolgen und der Form der Signalausschläge (56, 57) die Annäherungsphase (31) und die Entfernungsphase (41) zu ermitteln, und einem Aktuator (104), der von der Signalauswerteeinheit (101) angesteuert ist und eingerichtet ist, sobald die Annäherungsphase (31) oder die Entfernungsphase (41) ermittelt ist, den Schalter (103) zu betätigen.

2. Schalterbetätigungseinrichtung gemäß Anspruch 1, wobei das pyroelektrische Material Bleizirkonattitanat ist.

3. Schalterbetätigungseinrichtung gemäß Anspruch 1 oder 2, wobei der Präsenzsensor (1) mindestens zwei der Pixel (21 bis 24) aufweist.

4. Schalterbetätigungseinrichtung gemäß Anspruch 1 bis 3, wobei das Teil ein menschlicher Kopf (115) und die vom Teil emittierte Wärme die vom menschlichen Kopf (115) abgestrahlte Körperwärme ist.

5. Mobiles Gerät mit der Schalterbetätigungseinrichtung (100) gemäß einem der Ansprüche 1 bis 4, wobei der Schalter (103) zum Aktivieren/Deaktivieren einer Funktionalität des mobilen Geräts (114) in diesem verschaltet ist.

6. Verfahren zum Betreiben einer Schalterbetätigungseinrichtung (100) gemäß einem der Ansprüche 1 bis 4, mit den Schritten:
- Ausgegeben von dem Pixel (21 bis 24) der erste Signalausschlag (56) hervorgerufen in der Annäherungsphase (31) an die Signalauswerteeinheit (101), indem das Wärme emittierende Teil (115) an den Präsenzsensor (1) angenähert wird, wobei das Signal (51 bis 54) des Pixels (21 bis 24) durch die Signalauswerteeinheit (101) ausgewertet wird, so dass der erste Signalausschlag (56) als ein erster absoluter Amplitudenanstieg (32) auf ein erstes Extremum (81 bis 84) und, nach Verstreichen einer ersten Zeitspanne ab dem Beginn (91) des ersten absoluten Amplitudenanstiegs (32), ein erster absoluter Amplitudenabfall (33) auf einen Amplitudenwert, dessen Absolutwert zwischen einem ersten vorherbestimmten absoluten Amplitudenwert und dem Absolutwert des Signalniveaus (55), das bei einem Nichtansprechen des Pixels (21 bis 24) vorherrscht, liegt, von der Signalauswerteeinheit (101) identifiziert wird;
- Sobald der erste Signalausschlag (56) identifiziert wurde:
Ansteuern des Aktuators (104) zum Betätigen des Schalters (103) durch die Signalauswerteeinheit (101);
- Ab der Identifizierung des ersten Signalausschlags (56): Aussetzen der Auswertung des Signals (51 bis 54) des Pixels (21 bis 24) durch die Signalauswerteeinheit (101) eine vorherbestimmte Wartedauer, die die Wartephase (44) bildet;
- Ausgegeben von dem Pixel (21 bis 24) der zweite Signalausschlag (57) hervorgerufen in der Entfernungsphase (41) an die Signalauswerteeinheit (101), indem das Wärme emittierende Teil (115) von dem Präsenzsensor (1) entfernt wird, wobei das Signal (51 bis 54) des Pixels (21 bis 24) durch die Signalauswerteeinheit (101) ausgewertet wird, so dass der zweite Signalausschlag (57) als ein zweiter absoluter Amplitudenanstieg (42) auf ein zweites Extremum (71 bis 74) und, nach Verstreichen einer zweiten Zeitspanne ab dem Beginn (93) des zweiten absoluten Amplitudenanstiegs (42), einen zweiten absoluten Amplitudenabfall (43) auf einen Amplitudenwert, dessen Absolutwert zwischen einem zweiten vorherbestimmten absoluten Amplitudenwert und dem Absolutwert des Signalniveaus (55), das bei einem Nichtansprechen des Pixels (21 bis 24) vorherrscht, liegt, von der Signalauswerteeinheit (101) identifiziert wird;
- Sobald der zweite Signalausschlag (57) identifiziert wurde: Ansteuern des Aktuators (104) zum Betätigen des Schalters (103) durch die Signalauswerteeinheit (101).

7. Verfahren gemäß Anspruch 6, mit dem Schritt:
Überprüfen, ob die Absolutwerte der Amplituden der Signalausschläge (56, 57) über einem vorherbestimmten Amplitudenniveau liegen; Ist die Überprüfung positiv, Fortfahren mit dem jeweiligen nächsten Schritt.

8. Verfahren gemäß Anspruch 6 oder 7, wobei die Wartedauer zwischen 0 s und 5 s beträgt.

9. Verfahren gemäß einem der Ansprüche 6 bis 8, wobei die erste Zeitspanne höchstens zwischen 10 ms und 1000 ms liegt.

10. Verfahren gemäß einem der Ansprüche 6 bis 9, wobei die zweite Zeitspanne höchstens zwischen 10 ms und 1000 ms liegt.

11. Verfahren gemäß einem der Ansprüche 6 bis 10, wobei der erste vorherbestimmte absolute Amplitudenwert um 20 % bis 50 % größer ist als der Absolutwert des Signalniveaus (55), das bei einem Nichtansprechen des Pixels (21 bis 24) vorherrscht, bezogen auf den absoluten Amplitudenwert des ersten Extremums (81 bis 84).

12. Verfahren gemäß einem der Ansprüche 6 bis 11, wobei der zweite vorherbestimmte absolute Amplitudenwert höchstens um 20 % bis 50 % größer ist als der Absolutwert des Signalniveaus (55), das bei einem Nichtansprechen des Pixels (21 bis 24) vorherrscht, bezogen auf den absoluten Amplitudenwert des zweiten Extremums (81 bis 84).

13. Verfahren gemäß einem der Ansprüche 6 bis 12, mit dem Schritt:
- Überprüfen, ob das erste Extremum (81 bis 84) oberhalb und das zweite Extremum (71 bis 74) unterhalb des Signalniveaus (55) liegt, das bei einem Nichtansprechen des Pixels (21 bis 24) vorherrscht, oder ob das erste Extremum (81 bis 84) unterhalb und das zweite Extremum (71 bis 74) oberhalb des Signalniveaus (55) liegt, das bei einem Nichtansprechen des Pixels (21 bis 24) vorherrscht; Ist die Überprüfung positiv, Fortfahren mit dem jeweiligen nächsten Schritt.

14. Verfahren gemäß einem der Ansprüche 6 bis 13, wobei der Präsenzsensor (1) mindestens zwei der Pixel (21 bis 24) aufweist, mit den Schritten:
- Überprüfen, ob die ersten Signalausschläge (56) und die zweiten Signalausschläge (57) der Pixel (21 bis 24) jeweils innerhalb einer vorherbestimmten Zeitspanne liegen; Ist die Überprüfung positiv, Fortfahren mit dem jeweiligen nächsten Schritt.

15. Verfahren gemäß Anspruch 14, wobei die vorherbestimmte Zeitspanne 30 ms beträgt.

## Claims

1. A switch-actuating apparatus (100) with a presence sensor (1) for actuating a switch (103) by the presence of a heat-emitting part (115) on the presence sensor (1), wherein the presence is formed by an approach phase (31), in which the part (115) approaches the presence sensor (1), a persistence phase, in which the part (115) persists in the vicinity of the presence sensor (1), and a removal phase (41), in which the part (115) is to be moved away from the presence sensor (1), wherein the presence sensor (1) is configured to detect heat, which is emitted by the part (115), by means of at least one pixel (21 to 24), which has a thin film of pyroelectric material, and to output, per pixel (21 to 24), a signal (51 to 54) with signal deflections (56, 57) corresponding to the temporal intensity curve of the heat detected by the pixel (21 to 24), of a signal evaluation unit (101) which is configured to, from the chronological sequence and the shape of the signal deflections (56, 57), to determine the approach phase (31) and the distance phase (41), and an actuator (104) which is controlled by the signal evaluation unit (101) and is configured to activate the switch (103) as soon as the approach phase (31) or the distance phase (41) is determined.

2. A switch-actuating apparatus according to claim 1, wherein the pyroelectric material is lead zirconate titanate.

3. A switch-actuating apparatus according to claim 1 or 2, wherein the presence sensor (1) has at least two of the pixels (21 to 24).

4. A switch-actuating apparatus according to claims 1 to 3, wherein the part is a human head (115) and the heat emitted from the part is the body heat radiated from the human head (115).

5. A mobile device having the switch-actuating apparatus (100) according to any one of claims 1 to 4, wherein the switch (103) for activating/deactivating a functionality of the mobile device (114) is connected therein.

6. A method of operating a switch-actuating apparatus (100) according to any one of claims 1 to 4, with the steps:
- outputting the first signal deflection (56) from the pixel (21 to 24), generated in the approach phase (31), to the signal evaluation unit (101) by approaching the heat-emitting part (115) to the presence sensor (1), wherein the signal (51 to 54) of the pixel (21 to 24) is evaluated by the signal evaluation unit (101) so that the first signal deflection (56) as a first absolute amplitude increase (32) to a first extreme (81 to 84) and, after the elapse of a first time period from the beginning (91) of the first absolute amplitude increase (32), a first absolute amplitude decrease (33) to an amplitude value, the absolute value of which is between a first predetermined absolute amplitude value and the absolute value of the signal level (55), which predominates when the pixel (21 to 24) does not respond, is identified by the signal evaluation unit (101);
- as soon as the first signal deflection (56) has been identified:
controlling the actuator (104) to activate the switch (103) by the signal evaluation unit (101);
- from the identification of the first signal deflection (56): suspending the evaluation of the signal (51 to 54) of the pixel (21 to 24) by the signal evaluation unit (101) a predetermined waiting time which forms the waiting phase (44);
- outputting the second signal deflection (57) from the pixel (21 to 24), generated in the removal phase (41), to the signal evaluation unit (101) by removing the heat-emitting part (115) from the presence sensor (1), wherein the signal (51 to 54) of the pixel (21 to 24) is evaluated by the signal evaluation unit (101) so that the second signal deflection (57) as a second absolute amplitude increase (42) to a second extreme (71 to 74) and, after the elapse of a second time period from the beginning (93) of the second absolute amplitude increase (42), a second absolute amplitude decrease (43) to an amplitude value, the absolute value of which is between a second predetermined absolute amplitude value and the absolute value of the signal level (55) which predominates when the pixel (21 to 24) does not respond, is identified by the signal evaluation unit (101);
- as soon as the second signal deflection (57) has been identified: controlling the actuator (104) to activate the switch (103) by the signal evaluation unit (101)..

7. A method according to claim 6, with the step:
checking whether the absolute values of the amplitudes of the signal deflections (56, 57) lie above a predetermined amplitude level; if the checking is positive, proceeding with the respective next step.

8. A method according to claim 6 or 7, wherein the waiting time is between 0 s and 5 s.

9. A method according to any one of claims 6 to 8, wherein the first time period is at most between 10 ms and 1000 ms.

10. A method according to any one of claims 6 to 9, wherein the second time period is at most between 10 ms and 1000 ms.

11. A method according to any one of claims 6 to 10, wherein the first predetermined absolute amplitude value is 20% to 50% greater than the absolute value of the signal level (55) which predominates when the pixel (21 to 24) does not respond, based on the absolute amplitude value of the first extreme (81 to 84).

12. A method according to any one of claims 6 to 11, wherein the second predetermined absolute amplitude value is at most 20% to 50% greater than the absolute value of the signal level (55) which predominates when the pixel (21 to 24) does not respond, based on the absolute amplitude value of the second extreme (81 to 84).

13. A method according to any one of claims 6 to 12, with the step:
- checking whether the first extreme (81 to 84) lies above the signal level (55) and the second extreme (71 to 74) lies below the signal level (55) which predominates when the pixel (21 to 24) does not respond, or whether the first extreme (81 to 84) lies below the signal level (55), and the second extreme (71 to 74) lies above the signal level (55) which predominates when the pixel (21 to 24) does not respond; if the checking is positive, proceeding with the respective next step.

14. A method according to any one of claims 6 to 13, wherein the presence sensor (1) has at least two of the pixels (21 to 24), with the steps:
_ checking whether the first signal deflections (56) and the second signal deflections (57) of the pixels (21 to 24) are each within a predetermined time period; if the checking is positive, proceeding with the respective next step.

15. A method according to claim 14, wherein the predetermined time period is 30 ms.

## Revendications

1. Dispositif d'actionnement de commutateur (100) avec un capteur de présence (1) pour l'actionnement d'un commutateur (103) par la présence d'un élément émettant de la chaleur (115) au niveau du capteur de présence (1), dans lequel la présence est constituée d'une phase d'approche (31), dans laquelle l'élément (115) s'approche du capteur de présence (1), d'une phase de séjour, dans laquelle l'élément (115) séjourne à proximité du capteur de présence (1), et d'une phase d'éloignement (41), dans laquelle l'élément (115) doit être éloignée du capteur de présence (1), dans lequel le capteur de présence (1) est conçu pour détecter la chaleur émise par l'élément (115) au moyen d'au moins un pixel (21 à 24) comprenant un film mince en matériau pyro-électrique et pour émettre, par pixel (21 à 24), un signal (51 à 54) avec des déviations du signal (56, 57) correspondant au tracé de l'intensité en fonction du temps de la chaleur détectée par le pixel (21 à 24), une unité d'analyse de signaux (101), qui est conçue pour déterminer, à partir de la succession temporelle et de la forme des déviations du signal (56, 57), la phase d'approche (31) et la phase d'éloignement (41), et un actionneur (104), qui est contrôlé par l'unité d'analyse de signaux (101) et qui est conçu pour actionner le commutateur (103) dès que la phase d'approche (31) ou la phase d'éloignement (41) est déterminée.

2. Dispositif d'actionnement de commutateur selon la revendication 1, dans lequel le matériau pyro-électrique est le titanate de zirconate de plomb.

3. Dispositif d'actionnement de commutateur selon la revendication 1 ou 2, dans lequel le capteur de présence (1) comprend au moins des pixels (21 à 24).

4. Dispositif d'actionnement de commutateur selon la revendication 1 à 3, dans lequel l'élément est une tête humaine (115) et la chaleur émise par l'élément est la chaleur corporelle émise par la tête humaine (115).

5. Appareil mobile avec le dispositif d'actionnement de commutateur (100) selon l'une des revendications 1 à 4, dans lequel le commutateur (103) est branché dans celui-ci pour l'activation/désactivation d'une fonctionnalité de l'appareil mobile (114).

6. Procédé d'exploitation d'un dispositif d'actionnement de commutateur (100) selon l'une des revendications 1 à 4, avec les étapes suivantes :
- émission par le pixel (21 à 24) de la première déviation de signal (56) provoquée dans la phase d'approche (31) vers l'unité d'analyse de signaux (101), grâce au fait que l'élément émettant de la chaleur (115) s'approche du capteur de présence (1), dans lequel le signal (51 à 54) du pixel (21 à 24) est analysé par l'unité d'analyse de signaux (101), de façon à ce que la première déviation de signal (56) soit identifiée, par l'unité d'analyse de signaux (101), comme une première augmentation d'amplitude absolue (32) vers un premier extremum (81 à 84) et, après l'écoulement d'un premier laps de temps à partir du début (91) de la première augmentation d'amplitude absolue (32), une première diminution d'amplitude absolue (33) vers une valeur d'amplitude, dont la valeur absolue se trouve entre une première valeur d'amplitude absolue préalablement déterminée et la valeur absolue du niveau de signal (55), qui règne lors d'une non-réaction du pixel (21 à 24) ;
- dès que la première déviation de signal (56) a été identifiée : contrôle de l'actionneur (104) pour l'actionnement du commutateur (103) par l'unité d'analyse de signaux (101) ;
- à partir de l'identification de la première déviation de signal (56) : suspension de l'analyse du signal (51 à 54) du pixel (21 à 24) par l'unité d'analyse de signaux (101) pendant une durée d'attente prédéterminée, qui constitue la phase d'attente (44) ;
- émission par le pixel (21 à 24) de la deuxième déviation de signal (57) provoquée dans la phase d'éloignement (41) vers l'unité d'analyse de signaux (101), grâce au fait que l'élément émettant de la chaleur (115) est éloigné du capteur de présence (1), dans lequel le signal (51 à 54) du pixel (21 à 24) est analysé par l'unité d'analyse de signaux (101), de façon à ce que la deuxième déviation de signal (57) est identifiée, par l'unité d'analyse de signaux (101), comme une deuxième augmentation d'amplitude absolue (42) vers un deuxième extremum (71 à 74) et, après l'écoulement d'un deuxième laps de temps à partir du début (93) de la deuxième augmentation d'amplitude absolue (42), une deuxième diminution d'amplitude absolue (43) vers une valeur d'amplitude dont la valeur absolue se trouve entre une deuxième valeur d'amplitude absolue prédéterminée et la valeur absolue du niveau de signal (55), qui règne lors d'une non-réaction du pixel (21 à 24) ;
- dès que la deuxième déviation de signal (57) a été identifiée : contrôle de l'actionneur (104) pour l'actionnement du commutateur (103) par l'unité d'analyse de signaux (101).

7. Procédé selon la revendication 6, avec l'étape suivante :
vérification si les valeurs absolues des amplitudes des déviations de signaux (56, 57) se trouve au-dessus d'un niveau d'amplitude prédéterminé ; si la vérification est positive, continuation avec l'étape suivante.

8. Procédé selon la revendication 6 ou 7, dans lequel la duré d'attente est entre 0 s et 5 s.

9. Procédé selon l'une des revendications 6 à 8, dans lequel le premier laps de temps se trouve, au maximum, entre 10 ms et 1 000 ms.

10. Procédé selon l'une des revendications 6 à 9, dans lequel le deuxième laps de temps se trouve, au maximum, entre 10 ms et 1 000 ms.

11. Procédé selon l'une des revendications 6 à 10, dans lequel la première valeur d'amplitude absolue prédéterminée est de 20 % à 50 % plus grande que la valeur absolue du niveau de signal (55), qui règne lors d'une non-réaction du pixel (21 à 24), par rapport à la valeur d'amplitude absolue du premier extremum (81 à 84).

12. Procédé selon l'une des revendications 6 à 11, dans lequel la deuxième valeur d'amplitude absolue prédéterminée est au maximum de 20 % à 50 % plus grande que la valeur absolue du niveau de signal (55), qui règne lors d'une non-réaction du pixel (21 à 24), par rapport à la valeur d'amplitude absolue du deuxième extremum (81 à 84).

13. Procédé selon l'une des revendications 6 à 12, avec l'étape suivante :
- vérification si le premier extremum (81 à 84) se trouve au-dessus et le deuxième extremum (71 à 74) se trouve en dessous du niveau de signal (55) qui règne lors d'une non-réaction du pixel (21 à 24), ou si le premier extremum (81 à 84) se trouve en dessous et le deuxième extremum (71 à 74) se trouve au-dessus du niveau de signal (55) qui règne lors d'une non-réaction du pixel (21 à 24) ; si la vérification est positive, continuation avec l'étape suivante.

14. Procédé selon l'une des revendications 6 à 13, dans lequel le capteur de présence (1) comprend au moins deux des pixels (21 à 24), avec les étapes suivantes :
- vérification si les premières déviations de signaux (56) et les deuxièmes déviations de signaux (57) des pixels (21 à 24) se trouvent dans un laps de temps prédéterminé ; si la vérification est positive, continuation avec l'étape suivante.

15. Procédé selon la revendication 14, dans lequel le laps de temps prédéterminé est de 30 ms.
